# EUROPÄISCHE PATENTSCHRIFT

(11) **EP 3 722 040 B1**
(45) Veröffentlichungstag und Bekanntmachung des Hinweises auf die Patenterteilung: **20.08.2025**
(21) Anmeldenummer: 20160572.2
(22) Anmeldetag: 03.03.2020
(51) Int. Cl.: B23K 11/24

(54) **TRANSFORMATOREINRICHTUNG ZUM WIDERSTANDSSCHWEISSEN**
TRANSFORMER DEVICE FOR RESISTANCE WELDING
DISPOSITIF TRANSFORMATEUR POUR LE SOUDAGE PAR RÉSISTANCE

(30) Priorität: 09.04.2019 DE 102019205046
(43) Veröffentlichungstag der Anmeldung: 14.10.2020
(73) Patentinhaber: Robert Bosch GmbH, 70442 Stuttgart (DE)
(72) Erfinder: Scholz, Reinhard, 64711 Erbach (DE); Herr, Alexander, 64720 Michelstadt (DE)

(56) Entgegenhaltungen:
- EP-A1- 2 200 079
- DE-A1- 102005 058 351
- DE-A1- 102014 227 027
- DE-A1- 102015 225 909
- US-B2- 9 039 279

## Beschreibung

Die Erfindung betrifft eine Transformatoreinrichtung mit einem Transformator zum Widerstandsschweißen, wobei die Transformatoreinrichtung einen Gleichrichter mit mindestens einem Leistungsbauteil umfasst.

### Stand der Technik

Im Zuge des sogenannten Widerstandsschweißens oder Punktschweißens werden Werkstücke stoffschlüssig miteinander verbunden, wobei Schweißelektroden mit einer Elektrodenkraft gegen die zu verschweißenden Werkstücke gepresst werden. Die Schweißelektroden werden für die Dauer einer Stromzeit von einem Schweißstrom durchflossen. Durch eine Widerstandserwärmung der beiden zu verschweißenden Werkstücke an dem Schweißpunkt zwischen den Schweißelektroden werden die zu verbindenden Werkstücke bis zum Erreichen einer erforderlichen Schweißtemperatur erhitzt und bilden dabei eine Schmelze aus.

Ein Transformator hat dabei die Aufgabe die Netzspannung oder eine Ansteuerspannung auf eine niedrigere Sekundärspannung herabzusetzen, um den Schweißstrom auf eine Stromstärke von mehreren tausend Ampere zu erhöhen. Der Transformator induziert an seiner Sekundärwicklung eine niedrige Wechselspannung in der Größenordnung von ca. 10 Volt, welche gleichgerichtet wird. Über die Schweißelektroden und die zu verschweißenden Werkstücke fließt ein hoher Gleichstrom in der Größenordnung von 7 bis zu 50 kA, der für den Schweißvorgang verwendet wird. Bedingt durch die niedrige Schweißspannung und die hohen Ströme wird die Verlustleistung des Transformators hauptsächlich durch die Flussspannung der Halbleiterdioden zur Gleichrichtung des Schweißstromes bestimmt. Bei einer Trafoausgangsspannung beim Schweißen von 2,8 V und einer Flussspannung der Gleichrichterdioden von 0,7 Volt ergibt sich allein aufgrund des Spannungsabfalls über die Gleichrichterdioden eine Verlustleistung von 25% bezogen auf die Gesamtleistung des Schweißtransformators. Durch den Einsatz von Halbleiterschaltelementen mit einer geringeren Flussspannung ist es möglich die Verlustleistung zu reduzieren. Es ist bekannt, die Gleichrichterdioden unter anderem durch Schottky-Dioden oder durch Bipolartransistoren mit isolierter Gate Elektrode IGBT, Feldeffekttransistoren FET bzw. Metall-Oxyd Feldeffektransistoren MOSFET mit einer geeigneten Ansteuerung zu ersetzen, um die Verlustleistung zu reduzieren. Um die für den Schweißvorgang erforderlichen hohen Ströme gleichzurichten wird eine entsprechende Anzahl dieser Halbleiterschaltelemente parallelgeschaltet.

DE 10 2014 227 027 A1 zeigt ein Leistungshalbleiteransteuerung für ein Leistungsbauteil gemäß dem Oberbegriff von Anspruch 1.

US 9,039,279 B2 beschreibt ein System und ein Verfahren zur Überwachung des Betriebszustands eines IGBT in Echtzeit.

Die Schrift DE 10 2014 227 024 A1 der Anmelderin betrifft eine Anordnung zur Realisierung eines Leistungsbauteils zur Steuerung eines hohen elektrischen Stromes, wie er beim Widerstandsscheißen benötigt wird, in einer flachen Sandwichbauweise unter Verwendung von Stromplatten. Eine Platte dient als Stromeingangsplatte, eine zweite Platte dient als Stromausgangsplatte. Die Leistungshalbleiter sind auf einem Bauteilträger angeordnet. Der Bauteilträger ist zwischen Stromeingangs- und Stromausgangsplatte angeordnet. Bei den Leistungshalbleitern kann es sich um stromgesteuerte oder spannungsgesteuerte Halbleiter handeln wie beispielsweise Bipolar-Transistoren, IGBT, FET oder MOSFFET Halbleiter oder dergleichen. Das beschriebene Leistungsbauteil findet unter anderem Verwendung als gesteuerte Widerstandsschweißdiode zur Gleichrichtung des Schweißstromes, wie zuvor beschrieben.

Als Transformatoren werden für das Widerstandsschweißen seit einiger Zeit Mittelfrequenz-Transformatoren (MF-Transformatoren) eingesetzt. Die Frequenz mit der MF-Transformatoren betrieben werden, ermöglicht eine effektive Energieumwandlung und damit das Verwenden eines relativ kleinen und leichten Transformators. Der Markt tendiert aus Gründen immer höherer Anforderungen an die erforderlichen Bauräume zur Entwicklung immer kleinerer und leistungsfähigerer MF-Transformatoren. Der MF-Transformator kann verkleinert werden, indem man die Schaltfrequenz erhöht. Beim Widerstandsschweißen werden MF-Transformatoren mit einer Schaltfrequenz im Bereich von 1000 Hz eingesetzt. Eine solch hohe Schaltfrequenz vergrößert jedoch die Schaltverluste der eingesetzten Halbleiterschaltelemente.

Dies wiederum wirkt sich erschwerend auf die Kühlung der verwendeten Leistungshalbleitermodule für die Gleichrichtung des Schweißstromes aus. Für MF-Schweißtransformatoren wird deshalb ein geschlossener Kühlkreislauf empfohlen. Häufig bildet eine elektronische Leistungsstufe mit Leistungshalbleitern zur Gleichrichtung des Schweißstromes zusammen mit dem MF-Transformator eine bauliche Einheit. MF-Schweißtransformatoren sind in der Regel mit einer Wasserkühlung und einer Temperaturüberwachung versehen, denn zu hohe Temperaturen können sowohl das Wicklungspakets des MF-Transformators als auch die, für die Gleichrichtung des Schweißstromes verwendeten Halbleiterbauteile schädigen und zum Ausfall des MF-Schweißtransformators führen. Man kann dann zwar defekte Halbleiterbauteile erkennen, zum Beispiel den Ausfall defekter Leistungsdioden, ein Austausch des Transformators oder der Leistungsbauteile ist dann jedoch erforderlich und erfordert in einer Produktionsanlage nicht akzeptierbare Ausfallzeiten. Um diesen Ausfallzeiten vorzubeugen, wird versucht eine Überlast des Transformators zu erkennen und zu vermeiden. Das erfolgt meist mit einer Temperaturüberwachung. Die Temperaturüberwachung wird üblicherweise mittels Kaltleitern (positiver Temperaturkoeffizient, PTC) realisiert, welche in die Wicklungen der Primär- und Sekundärseite des Transformators eingebracht werden und somit die Wicklungstemperaturen überwachen. Durch Überlast können nämlich Spontanausfälle des Schweißtransformators auftreten. Deshalb ist es sinnvoll einen Überlastbetrieb zu erkennen.

Aus der Schrift DE 10 2009 041 404 A1 der Anmelderin ist eine Überwachungseinrichtung zum Schutz eines elektrischen Transformators bekannt. Eine Recheneinheit vergleicht während des Betriebs des Transformators erfasste, charakteristische Messdaten mit einer in einem Speicher abgelegten Vergleichsdatenreihe. Unter Berücksichtigung des Vergleichsergebnisses erfolgt eine Signalisierung der Belastung. Dazu werden die Einschaltdauern für die Leistungshalbleiter ermittelt und ihnen ein maximal zulässiger Strom zugeordnet. Die Recheneinheit vergleicht während des Betriebes die jeweils aktuell gemessenen Werte mit abgespeicherten Werten und leitet lastabhängig geeignete Schutzmaßnahmen ein. Mit der Überwachungseinrichtung ist es nun möglich Überlastsituationen des Schweißtransformators zu erkennen und auch zu verhindern. Ein Verschleiß der Halbleiterelement kann ebenfalls berechnet werden, indem die Einschaltdauer mit dem erfassten Schweißstrom bewertet wird. Nachteil dieser Lösung ist, dass der Einfluss der Kühlung nicht in Betracht gezogen wird.

DE 10 2005 058 351 A1 zeigt ein Verfahren und eine Vorrichtung zum Überwachen eines Schweißinverters zum Widerstandsschweißen. Hierbei wird ein Temperaturverlauf zum Überwachen des Schweißinverters, insbesondere zum Durchführen einer Lebensdauerabschätzung, aufgenommen.

Die Schrift DE 10 2011 119 184 A1 der Anmelderin offenbart ein Verfahren zur Bestimmung der Restlebensdauer von Elektronikschaltungen einer Windenergieanlage. Aus dem zeitlichen Verlauf der Temperatur wird die Nennlebensdauer der Elektronikschaltung ermittelt. Die Erfindung geht dabei von der Erkenntnis aus, dass die Bondverbindungen eines Halbleiters nur eine gewisse Anzahl von Temperaturschwankungen überstehen. Es wird davon ausgegangen, dass die Elektronikschaltung insgesamt ausfällt, wenn eine Bondverbindung ausfällt. Bei einem Leistungsbauteil in einer flachen Sandwichbauweise gemäß DE 10 2014 227 024 A1 treten Temperarturabfälle im Material wegen der schnellen Wärmeabfuhr jedoch kaum auf. Der Aufbau der Anordnung erfordert aufgrund der stabilen internen Verbindungen auch keine Druckkontaktierungen, so dass ein Ausfall eines Leistungsbauteils hauptsächlich durch die Lebensdauer der Halbleiterschaltelemente und dem Verschleiß des Kontaktmaterials zu den beiden Platten selbst bestimmt wird. Wird nun die oben erwähnte Mikrocontrollerschaltung zur Bestimmung der Restlebensdauer des Schweißtransformators auf einer Platine in einem Schweißtransformator verbaut, so muss diese selbst in die Berechnung des Lebensdauermodells einbezogen werden. Sie kann sogar zur bestimmenden Größe für die Lebensdauer des Schweißtransformators werden.

Aufgabe der vorliegenden Erfindung ist es deshalb, eine einfache und kostengünstige Überwachungseinrichtung für den Verschleißzustand der Leistungsbauteile eines Schweißtransformators unter Berücksichtigung des Einflusses des Kühlkreislaufes zur Verfügung zu stellen, die die Nachteile der vorgestellten Lösungen umgeht und die keine zusätzliche aufwändige elektronische Schaltung erfordert.

### Offenbarung der Erfindung

Leistungshalbleiter haben bekanntermaßen eine begrenzte Lebensdauer. Grundlage der vorliegenden Erfindung ist, dass bei bekannter Höhe des Temperaturhubs sowie bekannter Höhe der mittleren Temperatur - bei welcher besagter Temperaturhub erfolgt - auf die Lebensdauer von Leistungshalbleitern geschlossen werden kann. Grundlage dafür ist die Arrhenius-Gleichung, die die quantitative Temperaturabhängigkeit bei physikalischen und chemischen Prozessen näherungsweise beschreibt. Die Bewertung der Lebensdauer eines Leistungshalbleiters kann mit einer Bewertung der Temperaturverläufe bei den durchgeführten Schaltzyklen (Off/On/Off-Zyklen) erfolgen. Bestimmt wird der Verschleiß der Halbleiter somit durch die Anzahl der Sperrschichttemperaturhübe bei vorgegebener Offsettemperatur. Ganz grob bedeutet beispielsweise bei den heutigen Schweißdioden ein Hub von 60 °K etwa eine Lebensdauer von 10 Millionen Schweißungen bei einer mittleren Temperatur von 70 °C. Mit größerer Offsettemperatur erhöht sich der Verschleiß und die Lebensdauer des Leistungshalbleiters verringert sich. Die Halbleiterhersteller geben in ihren Datenblättern Auskunft darüber, inwieweit sich die Lebensdauer in Abhängigkeit von der Höhe der Temperaturhübe und der Höhe der Offsettemperatur verringert. Grundlage für die Berechnung der Restlebensdauer des Leistungshalbleiters ist somit die Erfassung der Temperatur in der Sperrschicht des Leistungshalbleiters. So ist die Lebensdauerfunktion eines Leistungshalbleiters zum einen abhängig von der Höhe des Temperaturhubes der Sperrschichttemperatur, zum anderen von der mittleren Sperrschichttemperatur. Herkömmliche Schweißdioden bestehen aus einer Siliziumscheibe zwischen zwei Metallscheiben. Solche Bauelemente sind druckkontaktiert, so dass es hier keine Möglichkeit gibt sperrschichtnah einen Temperaturfühler zu platzieren.

Vor diesem Hintergrund wird eine Transformatoreinrichtung mit einem Transformator zum Widerstandsschweißen mit den Merkmalen von Patentanspruch 1 vorgeschlagen, wobei die Transformatoreinrichtung einen Gleichrichter mit mindestens einem Leistungsbauteil umfasst.

Für das in Anspruch 1 genannte Leistungsbauteil mit Stromeingangsplatte, Stromausgangsplatte und mit einem Bauteilträger wird zwischen diesen Platten ein Temperaturfühler vorgesehen, der zwischen der Stromeingangsplatte und der Stromausgangsplatte und zwischen den mindestens zwei Leistungshalbleiterventilen angeordnet ist. Durch diese Anordnung des Temperaturfühlers, kann die mittlere Temperatur der Leistungshalbleiterventile und deren Gradient über der Zeit sehr einfach, genau und nah an der Sperrschicht der Leistungshalbleiterventile - zumindest nah am Halbleitermaterial - erfasst werden. Die so gemessene Temperatur kann sogar näherungsweise mit der oben genannten Sperrschichttemperatur gleichgesetzt werden, weil bei einem Leistungsbauteil in dieser Bauweise Temperarturabfälle im Material wegen der schnellen Wärmeabfuhr kaum auftreten. Diese somit sperrschichtnahe Temperaturmessung ermöglicht während der Schaltzyklen der Leistungshalbleiter die Erfassung sowohl des Offsetniveaus der Temperatur, wodurch der Einfluss der Wasserkühlung berücksichtigt ist, als auch die Ermittlung der Änderungen der Sperrschichttemperatur der verwendeten Halbleiterventile über der Zeit und damit der Höhe des Temperaturhubes. Durch geeignete Auswertung zum Beispiel in einer Auswerteeinrichtung des Schweißtransformators, in einer Auswerteeinrichtung der Schweißsteuerung bzw. in einer externen Verarbeitungseinheit ist somit die Ermittlung des Lebensdauerendes sowie die Signalisierung des Zeitpunktes eines Austausches des Transformators möglich, ohne dass weitere elektronische Schaltungen die Lebensdauer des Transformators einschränken. Dafür kann z.B. eine Aggregation von Temperaturhüben erfolgen, z.B. segmentiert nach Höhe des einzelnen Temperaturhubs und Offsettemperatur.

Versagt die Kühlung des Schweißtransformators, so wird das in kurzer Zeit zum Ausfall des Schweißtransformators führen. Deshalb sind nach dem Stand der Technik Maßnahmen vorgesehen, einen Ausfall des Kühlsystems zu erkennen. Dies geschieht in der Regel durch Sensorik für Durchflussmessung, Druckmessung oder Temperaturmessung im Kühlkreislauf. Ein Ausfall des Kühlsystems bewirkt eine Erhöhung des Temperaturniveaus im Leistungsbauteil, was zuverlässig durch Auswertung des Offsetniveaus des Temperaturfühlersignals erkannt wird. Dadurch kann die im Stand der Technik notwendige Sensorik zur Erkennung eines Ausfalls des Kühlsystems entfallen und somit allein durch Auswertung des Temperaturfühlersignals erfolgen. Mit dem ohnehin erfindungsgemäß vorhandenem Temperaturfühler kann somit auch der Ausfall des Kühlsystems erkannt werden, und zwar rechtzeitig bevor eine Zerstörung des Leistungsbauteils erfolgt. Damit lassen sich in besonders vorteilhafter und einfacher Art und Weise zum einen die Ausfallzeiten durch vorbeugenden Austausch der Leistungsbauteile des Schweißtransformators vor Ende der Lebensdauer verhindern, zum anderen lässt sich einer Zerstörung des Leistungsbauteils bei Ausfall des Kühlsystems zuvorkommen.

Vorteilhafte Weiterbildungen sind Gegenstand der Unteransprüche sowie der nachfolgenden Beschreibung.

Als Temperaturfühler wird besonders vorteilhaft ein Heißleiter mit einem negativen Temperaturkoeffizienten auf Siliziumbasis eingesetzt. Diese Heißleiter werden in einem Temperaturbereich von -50 °C bis +150 °C eingesetzt und zeichnen sich durch geringe Baugröße, enge Toleranzen und gute Langzeitstabilität aus. Damit ist eine sehr genaue Temperaturmessung möglich.

Besonders vorteilhaft ist es zudem, den Temperaturfühler auf dem Bauteilträger des Leistungsbauteils anzuordnen. Dadurch ist der Temperaturfühler in unmittelbarer Nähe der Halbleiterschaltelemente platziert und kann dadurch eine der Sperrschichttemperatur nahekommende Temperatur der verwendeten Halbleiter sehr genau erfassen.

Weiterhin von Vorteil ist es, den Anschluss des Temperaturfühlers und/oder den wenigstens einen Steueranschluss zur Ansteuerung der Leistungshalbleiterventile des Leistungsbauteils zu Kontakten eines Steckers des Bauteilträgers des Leistungsbauteils nach außen zu führen.

Wenn der Stecker des Bauteilträgers des Leistungsbauteils seitlich über die Stromeingangsplatte die Stromausgangsplatte heraussteht, ist es besonders einfach das Leistungsbauteil mit den Anschlüssen für die Steuerung und den Temperaturfühler zu kontaktieren. Solch ein Leistungsbauteil ist für die Gleichrichtung des Ausgangsstromes der Sekundärwicklung eines erfindungsgemäßen Schweißtransformators besonders gut geeignet, da es sowohl für die hohen Schweißströme und die niedrigen Spannungen - welche auf der Sekundärseite des Transformators auftreten - ausgelegt ist und einen Stecker auf dem Bauteilträger sowohl für die Kontakte der Ansteuerung, als auch für den Temperaturfühler aufweist. Eine bauliche wassergekühlte Einheit aus Transformator und Leistungsbauteil lässt sich einfach und kostengünstig realisieren. Eine Ansteuereinrichtung, die dazu eingerichtet ist, den Steueranschluss des Leistungsbauteils zur Gleichrichtung des elektrischen Starkstromes zu steuern, kann einfach durch direkte oder indirekte Steckverbindung mit den Kontakten des Steckers des Bauteilträgers kontaktiert werden. Eine Erfassungseinrichtung die, dazu eingerichtet ist das Signal des Temperaturfühlers zu erfassen, kann ebenfalls einfach durch direkte oder indirekte Steckverbindung mit dem Stecker des Bauteilträgers kontaktiert werden. Der Stecker kann auch als überstehender Abschnitt einer den Bauteilträger bildenden Platine ausgebildet sein. Die Erfassung der sperrschichtnahen Temperaturmessung mit besagter Erfassungseinrichtung ermöglicht die Ermittlung der Schaltzyklen, die Auswertung des Offsetniveaus der Temperatur, wodurch der Einfluss der Wasserkühlung berücksichtigt ist, als auch die Ermittlung der Änderungen der Sperrschichttemperatur der verwendeten Halbleiterventile über der Zeit.

Wenn weiterhin eine mindestens erste Kommunikationseinrichtung vorhanden ist und dazu eingerichtet ist, den gemessenen zeitlichen Verlauf der sperrschichtnahen Temperatur der mindestens zwei Leistungshalbleiterventile des Leistungsbauteils an eine Schweißsteuerung und/oder an eine externe Verarbeitungseinrichtung zu übertragen, kann die Berechnung der verbleibendenden Lebensdauer in der Schweißsteuerung und/oder in der externen Verarbeitungseinheit erfolgen.

Dies hat den Vorteil, dass keine zusätzliche elektronische Schaltung für die Ermittlung der verbleibenden Lebensdauer des Leistungsbauteils und damit des Schweißtransformators im Schweißtransformator selbst erforderlich ist, die selbst einen, wie bereits oben beschriebenen, Einfluss auf den Verschleiß des Schweißtransformators hätte.

Denkbar ist es auch, dass die Berechnung der verbleibenden Restlebensdauer in einer Auswerteeinrichtung, die in der Schweißtransformatoreinrichtung angesiedelt ist, erfolgt. Berechnungsgrundlage bildet - wie zuvor bereits angedeutet - eine mit der Offsettemperatur bewertete Aggregation der Temperaturhübe wie nachfolgend anhand eines Ausführungsbeispiels noch näher beschrieben wird. Wird ein vorgegebener Schwellwert der bewerteten Temperaturhübe überschritten, so ist der Wartungszeitpunkt gegeben.

Wenn die Auswerteeinrichtung zur Kalkulation des Wartungszeitpunktes und/oder des prognostizierten Lebensdauerendes in der Schweißsteuerung und/oder in der externen Verarbeitungseinrichtung angesiedelt ist, kann die Berechnung der verbleibendenden Lebensdauer in der Schweißsteuerung und/oder in der externen Verarbeitungseinheit erfolgen.

Von besonderen Vorteil ist es, den in der Schweißsteuerung oder der externen Verarbeitungseinrichtung berechneten Wartungszeitpunkt über die Kommunikationseinrichtung zurück an den Schweißtransformator zu übertragen.

Mit einer Signalisierungseinrichtung der Transformatoreinrichtung kann der erreichte Wartungszeitpunkt und/oder das prognostizierte Lebensdauerende der Transformatoreinrichtung direkt an der Transformatoreinrichtung angezeigt werden.

Wenn der Wartungszeitpunkt erreicht ist, kann die Notwendigkeit eines Austausches des Transformators oder des erfindungsgemäßen Leistungsbauteiles auch über eine weitere Kommunikationseinrichtung an eine übergeordnete Produktionsleiteinrichtung oder eine App an ein mobiles Usergerät, wie ein Smartphone oder ein Tablet gemeldet werden.

Von besonderem Vorteil sind hier insbesondere Kommunikationseinrichtungen die über ein Protokoll wie Bluetooth, LoRa und/oder ZigBee drahtlos kommunizieren. Während Lora ist ein Kommunikationsstandard für Funkverbindungen großer Reichweite ist, spezifiziert ZigBee ist drahtlose Netzwerke kurzer Reichweite. Denkbar ist jedoch auch eine kabelgebundene Kommunikation über Ethernet oder Sercos. Sercos ist eine normierte digitale Schnittstelle zur Kommunikation zwischen Steuerungen und Feldbusteilnehmern.

Über einen zweiten Kanal kann die Erfassungseinrichtung weiterhin dazu eingerichtet sein, den zeitlichen Spannungsverlauf an den Schweißelektroden und/oder den zeitlichen Stromverlauf der Sekundärwicklung und/oder der Primärwicklung des Transformators zu erfassen. Damit können insbesondere Überlastsituationen des Leistungsbauteils erkannt und verhindert werden. In einem solchen Fall kann beispielsweise der Schweißstrom abgeschaltet werden, um Folgeschäden durch Überlast zu vermeiden. Dies ermöglicht insbesondere das Verhindern von vorzeitigen Ausfällen des Leistungsbauteils und damit der Schweißtransformatoreinrichtung zum Beispiel durch Überspannungen und zu hohe Ströme. Das kann insbesondere bei Schweißen von falschen Materialen mit zu geringem Widerstand auftreten oder bei Kurzschlüssen an den Schweißelektroden auftreten.

Besonders vorteilhaft ist es, diese für eine adaptive Schweißregelung ASR ohnehin erfassten Spannungen und/oder Ströme sowie die für die Ansteuereinrichtung ohnehin erfassten Spannungsabfälle über die Leistungshalbleiter über die erste Kommunikationseinrichtung an die Schweißsteuerung und/oder an die externe Verarbeitungseinrichtung zu übertragen. Dadurch wird es möglich, aus dem erfassten Spannungs- und/oder Stromverlauf in der Auswerteeinrichtung den Istzustand des Verschleißes der Halbleiterventile zu berechnen. Dies erfolgt durch Berechnung des Durchlasswiderstandes des durchgeschalteten Leistungshalbleiters. Aus dem Wert des Durchlasswiderstandes bezogen auf einen Anfangswert des Durchlasswiderstandes des Leistungshalbleiters kann nämlich auf seinen aktuellen Verschleißzustand geschlossen werden. Aus dem Stand der Technik ist bekannt, dass sich der Durchlasswiderstand des Leistungshalbleiters im Laufe der Zeit erhöht. Bei Feldeffekttransistoren wird dieser Durchlasswiderstand als R_{DSON} bezeichnet. Der Name setzt sich aus dem Kürzel für den Drain/Source Widerstand R_{DS} und dem englischen Wort "On", das den durchgeschalteten Zustand des Feldeffekttransistors kennzeichnet, zusammen. Aus dem aktuellen Wert des Durchlasswiderstandes bezogen auf den Wert des Durchlasswiderstandes zu Beginn der Lebensdauer des Leistungshalbleiters sowie aus dessen zeitlichen Verlauf kann auf den aktuellen Verschleißzustand der Leistungshalbleiter geschlossen werden. So deutet eine plötzliche Erhöhung des Wertes von R_{DSON} auf einen kurz bevorstehenden Ausfall des Leistungshalbleiters hin. Da für die Regelung des Schweißstromes sowie für die Ermittlung des Widerstandes an der Schweißstelle, Strom- und Spannung an der Schweißstelle ohnehin gemessen werden, kann ohne Einsatz zusätzlicher Sensorik der aktuelle Wert des Durchlasswiderstandes des Leistungshalbleiters sowie dessen Änderung für die Berechnung des Lebensdauerendes des Leistungsbauteils verwendet werden.

Die Auswerteinheit kann wie bereits oben beschrieben in der Schweißsteuerung als auch in einer externen Verarbeitungseinrichtung angesiedelt sein.

Denkbar ist es auch, dass die Kalkulation des erreichten Wartungszeitpunkts und/oder das prognostizierte Lebensdauerende der Transformatoreinrichtung unter Berücksichtigung des kalkulierten Verschleißes aufgrund der Berechnung des Kennwertes R_{DSON} und dessen zeitlichen Verlauf über der Zeit erfolgt.

Die Verfahren können vorteilhaft kombiniert werden. Während die Aggregation von Temperaturhüben eine Prognose eines Wartungs- oder Ausfallzeitpunktes erlaubt, erlaubt die Messung des Durchlasswiderstandes R_{DSON} eine aktuelle Einschätzung des Verschleißzustandes. Die Prognose könnte z.B. dann mit der aktuellen Einschätzung angepasst und verfeinert werden, z.B. könnte ein Wartungszeitraum nach hinten verschoben werden, wenn der Durchlasswiderstandes R_{DSON} einen geringeren Verschleiß des Leistungshalbleiters anzeigt, als es sich aus der Aggregation der Temperaturhübe errechnet.

Weitere Vorteile ergeben sich aus der nachfolgenden Beschreibung.

### Ausführungsbeispiele

Die Erfindung wird nun anhand eines Ausführungsbeispiels mit Hilfe der beigefügten Figuren näher beschrieben:
Darin zeigen:
- Fig. 1: eine Anordnung zur Realisierung eines Leistungsbauteils zur Steuerung eines elektrischen Stromes, und
- Fig. 2: schematisch eine bevorzugte Ausgestaltung einer erfindungsgemäßen Transformatoreinrichtung.

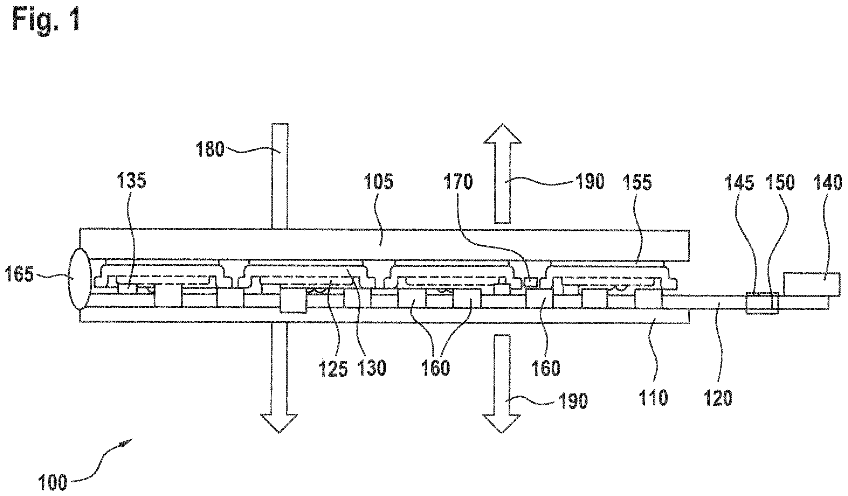

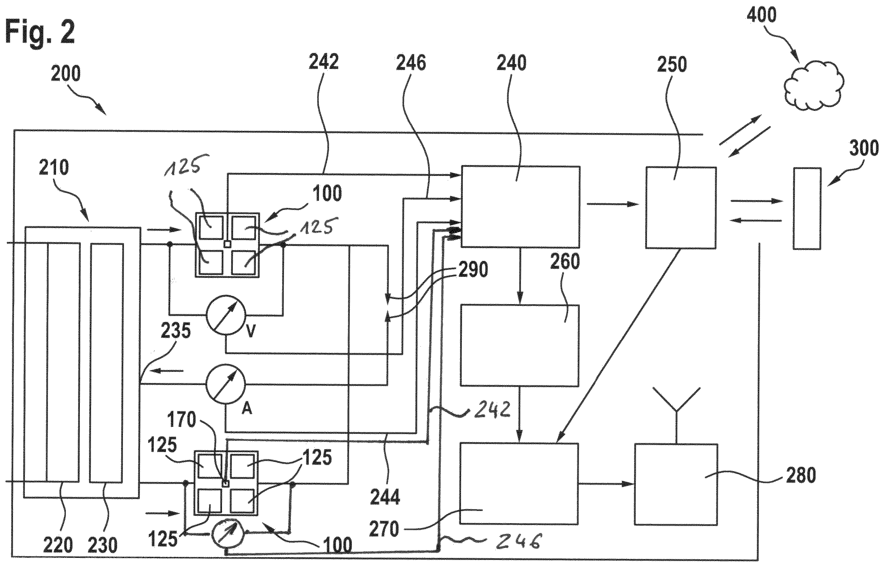

Identische Bezugszeichen in den Figuren 1 und 2 bezeichnen gleiche oder baugleiche Elemente.

Fig. 1 zeigt ein Leistungsbauteil 100 bestehend aus einer Stromeingangsplatte 105 und einer Stromausgangsplatte 110. Zwischen der Stromeingangsplatte 105 und der Stromausgangsplatte 110 ist ein Bauteilträger 120 in Form einer Leiterplatte angeordnet. Auf dem Bauteilträger 120 sind mehrere Leistungshalbleiter 125 angeordnet. Die Leistungshalbleiter 125 haben jeweils ein Metallgehäuse 130, welches mit dem Stromeingang der Leistungshalbleiter 125 verbunden ist. Das Metallgehäuse 130 der Leistungshalbleiter 125 ist mit der Stromeingangsplatte 105 mittels Löten oder Sintern unmittelbar elektrisch leitend verbunden. Hierzu wird auf die Gehäuse 130 der Halbleiter 125 Lot- oder Sinterpaste 155 flächig aufgetragen. Die den Gehäusen 130 der Halbleiter 125 zugewandte Innenfläche der Stromeingangsplatte 105 ist, abgesehen von den Kontaktstellen mit den Metallgehäusen 130 der Leistungshalbleiter 130, mit einem Lötstopplack (nicht dargestellt) versehen, welcher Lot-oder Sintermaterial 155 abstößt. Die Stromausgänge der Leistungshalbleiter 125 sind mit der Stromausgangsplatte 110 mittelbar mittels elektrischer Verbindungsmittel 160, als vertikale Durchkontaktierungen durch den Bauteilträger 120, mittels Löten und/oder Sintern und/oder mittels Kupferdomen (nicht dargestellt), welche Bestandteil der Stromausgangsplatte 110 sein können, elektrisch leitend verbunden. Auch hier kann ein Lötstopplack auf der Stromausgangsplatte 110, bis auf die Kontaktstellen mit dem Verbindungsmittel, vorgesehen sein.

Vorzugsweise kommt ein flaches Gehäuse 130 zum Einsatz, welches den Leistungshalbleiter 125 zumindest einseitig schützt, eine gute Wärmeleitfähigkeit aufweist und eine großflächige Anbindung an die Platten 105, 110 erleichtert. Der gegenüberliegende Stromausgang des Leistungshalbleiters 125 ist ohne Gehäuse frei zugänglich ausgeführt. Denkbar ist jedoch auch, in einem solchen Leistungsbauteil 100 Leistungshalbleiter 125 ohne eigenes Gehäuse zu verwenden. Wichtig ist, dass die Leistungshalbleiter 125 großflächige Stromeingänge und Stromausgänge aufweisen, um die Verluste, bedingt durch die Übergangswiderstände zwischen Stromeingangsplatte 105, Leistungshalbleiter 125 und Stromausgangsplatte 135 zu reduzieren. Weiterhin müssen die Leistungshalbleiter 125 zur Übertragung hoher Ströme im kA-Bereich geeignet sein. Als elektrisch leitfähige Stromeingangs-/Stromausgangsplatte 105, 110 sind Kupferplatten vorgesehen. Ein Steueranschluss 135 für die Leistungshalbleiter 125 ist ebenfalls dargestellt.

Im hier gezeigten Ausführungsbeispiel sind die Stromeingänge mehrerer MOSFET-Leistungshalbleiter 125 mit der Stromeingangsplatte 105 und die Stromausgänge dieser MOSFET-Leistungshalbleiter 125 mit der Stromausgangsplatte 110 verbunden. Beide Kupferplatten 105, 110 sind parallel und in einem geringen Abstand zueinander angeordnet. Alle Steueranschlüsse 135 der Halbleiter 125 sind auf der Leiterplatte des Bauteilträgers 120 elektrisch verbunden. Der gemeinsame Steueranschluss 135 ist zu seitlich auf der Leiterplatte des Bauteilträgers 120 angeordneten Kontakten 145 herausgeführt und von außen über einen Stecker 150 zugänglich. Die Ansteuereinrichtung 140 wird mit dem Bauteilträger 120 mittels der Kontakte 145 des Steckers 150 des Bauteilträgers 120 elektrisch verbunden. Die parallel und in ihrem Randbereich bündig zueinander angeordneten Kupferplatten 105, 110 sind mindestens in ihrem Randbereich mittels eines elektrisch nicht leitfähigen Platten-Verbindungsmittels 165 miteinander verbunden, so dass die Kupferplatten 105, 110 mit dem Verbindungsmittel 165 ein Gehäuse für das Leistungsbauteil 100 bilden.

Der während des Betriebs der Transformatoreinrichtung 200 fließende elektrische Starkstrom 180 kann mittels der Steueranschlüsse 135 der Leistungshalbleiter 125 gesteuert werden. Die durch den Stromfluss 180 erzeugte Wärme in den Leistungshalbleitern 125 kann in Richtung der Stromeingangsplatte 105 und in Richtung der Stromausgangsplatte 110 von den Leistungshalbleitern 125 abgeführt werden. Dieses Verhalten soll mittels der in Fig. 1 gezeigten Pfeile 190 angedeutet sein. Ein Temperaturfühler 170 ist in unmittelbarer Nähe zu den Leistungshalbleitern 125 auf dem Bauteilträger 120 angeordnet. Als Temperaturfühler 170 wird besonders vorteilhaft ein Heißleiter mit einem negativen Temperaturkoeffizienten auf Siliziumbasis eingesetzt. Diese Heißleiter werden in einem Temperaturbereich von -50 °C bis +150 °C eingesetzt und zeichnen sich durch geringe Baugröße, enge Toleranzen und gute Langzeitstabilität aus. Damit ist eine sehr genaue Temperaturmessung möglich. In Fig. 1 ist der Temperaturfühler 170 direkt an einer der Durchkontaktierungen 160 durch den Bauteilteilträger 120 angeordnet. Somit ist der Temperaturfühler 170 in unmittelbarer Nähe des Halbleiters 125 platziert und kann dadurch eine der Sperrschichttemperatur sehr nahekommende Temperatur des Halbleiters 125 sehr genau erfassen. In der Fig. 1 sind vier Leistungshalbleiter 125 dargestellt. Denkbar ist es weitere Temperaturfühler (nicht gezeigt) an den Durchkontaktierungen der Stromausgänge weiterer Leistungshalbleiter 125 anzuordnen. Dies ermöglicht eine ortsaufgelöste Erfassung der Temperatur der Leistungshalbleiter 125 des Leistungsbauteils 100. Die Anschlüsse des Temperaturfühlers 170 und der ggf. weiteren Temperaturfühler sind auf der Leiterplatte des Bauteilträgers 120 zum Steckverbinder 145 geführt und sind von außen über den Steckverbinder 145 zugänglich. Besonders vorteilhaft ist es die Signale des Temperaturfühlers 170 oder aller Temperaturfühler über einen gemeinsamen Bus zum Steckverbinder 145 zu führen. Denkbar ist hier ein 1-Draht-Bus (1-Wire), ein I²C Bus oder auch ein Feldbus. Der Anschluss bzw. die Anschlüsse für die Temperaturfühler 170 ist/sind seitlich mittels Kontakten 145 auf dem Bauteilträger 120 herausgeführt und damit von außen über den Steckverbinder 150 zugänglich.

Die in Fig. 1 gezeigte Ausführungsform ist lediglich grob schematisch zu sehen und soll keine Begrenzung der Anzahl der verwendeten Leistungshalbleiter 125 und der verwendeten Temperaturfühler 170 nahelegen. Im Prinzip können beliebig viele Leistungshalbleiter 125 auf diese Weise parallelgeschaltet und auch beliebig viele Temperaturfühler 170 auf dem Leistungsbauteil 100 angeordnet sein und mit der Erfassungseinrichtung 240 erfasst werden. Denkbar ist es insbesondere das jedem Leistungshalbleiter 125 ein Temperaturfühler 170 zugeordnet wird. Es können z.B. die Leistungshalbleiter 125 in mehreren Reihen und Spalten angeordnet sein. Mehrere Temperaturfühler 170 können in vorgegebenen, ggf. gleichmäßigen Abständen zwischen den Reihen oder auch in Form einer Matrix angeordnet sein.

Fig. 2 zeigt schematisch eine beispielhafte Ausgestaltung eines erfindungsgemäßen Transformatoreinrichtung 200. Die Transformatoreinrichtung 200 umfasst einen Transformator 210 mit Primärwicklung 220 und Sekundärwicklung 230. Eingangsspannung für die Primärwicklung 220 des Transformators 210 ist eine pulsweitenmodulierte (PWM) Spannung im Bereich zwischen ca. -500 und +500 Volt mit einem Tastgrad zwischen 0 und 100% bei einer Periodendauer im Bereich einer Millisekunde. Ausgangsspannung an der Sekundärwicklung 230 des Transformators 210 ist eine Spannung im Leerlauf zwischen -10 und +10V und einer Stromstärke von z.B. 7 kA bis zu 50 kA für typische Schweißanwendungen.

Für die Gleichrichtung des elektrischen Starkstromes 180 der Sekundärwicklung 230 werden im Ausführungsbeispiel zwei Leistungsbauteile 100 wie oben beschrieben verwendet, die in dieser Figur lediglich schematisch dargestellt sind. Denkbar ist es auch, mehr als zwei Leistungsbauteile 100 für die Gleichrichtung des Schweißstromes 180 einzusetzen. Die Leistungsbauteile 100 umfassen jeweils mehrere, z.B. vier, 9, 16, 25, oder 36 Leistungshalbleiter 125 sowie einen Temperaturfühler 170. Auch andere Zahlen der Leistungshalbleiter 125 sind natürlich denkbar. Es wäre jedoch auch denkbar nur eines der beiden Leistungsbauteile 100 mit einem Temperaturfühler 170 auszustatten, z.B. für einen Betriebsfall in dem die beiden Leistungsbauteile 100 etwa gleich stark belastet sind. Wenn es aufgrund baulicher Gegebenheiten Unterschiede in der Kühlung gibt, wird in zweckmäßiger Weise das Leistungsbauteil 100 mit der weniger guten Kühlanbindung mit dem Temperaturfühler 170 ausgestattet. Denkbar ist es auch, wie zuvor in Fig. 1 beschrieben, mehrere Temperaturfühler 170 auf jedem Leistungsbauteil 100 anzuordnen, um wie oben beschrieben eine genauere bzw. eine ortsaufgelöste Temperatur der Leistungshalbleiter 125 zu erfassen und auszuwerten. Insbesondere ist es möglich Temperaturfühler 170 so anzuordnen, dass jedem Leistungshalbleiter 125 ein Temperaturfühler zugeordnet ist.

Der Transformator 210 hat ein Übersetzungsverhältnis von ca. 50. Das heißt, er transformiert die Spannung von ca. 500 Volt der Primärwicklung 220 in eine Spannung im Bereich von ca. 10V der Sekundärwicklung 230. Die Sekundärwicklung 230 hat eine Mittelanzapfung 235 die mit einem Pol der Schweißelektroden 290 verbunden ist. Liegt an der Primärwicklung 220 eine positive Spannung an, so liegt an der Sekundärwicklung 230 ebenfalls eine positive Spannung an. In dieser Phase schaltet das obere Leistungsbauteil 100 durch, während das untere Leistungsbauteil 100 gesperrt ist und an den Schweißelektroden 290 liegt eine positive Spannung an. Der Schweißstrom 180 fließt von der oberen Anzapfung der Sekundärwicklung 230 des Transformators 210 über das obere Leistungsbauteil 100, über die Schweißelektroden 290 zur Mittelanzapfung 235 der Sekundärwicklung 230 des Transformators 210. Liegt an der Primärwicklung 220 eine negative Spannung an, so liegt an der Sekundärwicklung 230 ebenfalls eine negative Spannung an. In dieser Phase schaltet das untere Leistungsbauteil 100 durch, während das obere Leistungsbauteil 100 gesperrt ist und an den Schweißelektroden 290 liegt wiederum eine positive Spannung an. Der Schweißstrom 180 fließt von der unteren Anzapfung der Sekundärwicklung 230 des Transformators 210 über das untere Leistungsbauteil 100, über die Schweißelektroden 290 zur Mittelanzapfung 235 der Sekundärwicklung 230 des Transformators 210.

Der zeitliche Verlauf des Schweißstromes 244, des Spannungsabfalls 246 über die Leistungshalbleiter 125 sowie zumindest der von den Temperaturfühlern 170 der beiden Leistungsbauteile 100 gemessenen Temperaturen 242 wird durch eine Erfassungseinrichtung 240 erfasst. Die Ausgänge des Stromsensors, des Spannungssensors an den Leistungshalbleitern 125 sowie der Temperaturfühler 170 der Leistungsbauteile 100 sind dazu mit dem Eingang der Erfassungseinrichtung 240 elektrisch verbunden. Besonders vorteilhaft ist es, die Signale aller Sensoren über einen gemeinsamen Bus zur Erfassungseinrichtung 240 zu führen. Denkbar ist hier ein 1-Draht-Bus (1- Wire), ein I²C Bus oder auch ein Feldbus.

Die Erfassungseinrichtung 240 erfasst den zeitlichen Verlauf des Schweißstromes 180, des Spannungsabfalls 246 über die Leistungshalbleiter 125 sowie den Temperaturverlauf der vom Temperaturfühler 170 gemessenen Temperatur der Leistungshalbleiter 125 der Leistungsbauteile 100. Der Temperaturfühler 170 ist dafür in unmittelbarer Nähe des Leistungshalbleiters 125 platziert und kann deshalb eine der Sperrschichttemperatur sehr nahekommende Temperatur des Halbleiters 125 sehr genau messen. Die Erfassungseinrichtung 240 ist Bestandteil der Schweißtransformatoreinrichtung 200, ebenso wie die der Transformator 210 und die Leistungsbauteile 100.

Weiterhin umfasst die Transformatoreinrichtung 200 eine Auswerteeinrichtung 260. Der Auswerteeinrichtung 260 werden die mit der Erfassungseinrichtung 240 erfassten Messdaten der Sensoren zugeführt. In der Auswerteinrichtung 260 erfolgt die Berechnung des Wartungszeitpunktes und/oder des prognostizierten Lebensdauerendes der Transformatoreinrichtung 200 auf Basis des mit der Erfassungseinrichtung 240 gemessenen zeitlichen Verlaufs der genannten einzelnen oder kombinierten Messwerte der Sensoren.

Eine Grundlage ist die Bestimmung der Anzahl der Sperrschichttemperaturhübe mit den Randbedingungen Offsettemperaturniveau und Temperaturgradient dϑ/dt. Auf diese Weise lassen sich Erkenntnisse über die Betriebsbelastung der Leistungshalbleiter 125 sowie Alterungsindikatoren ableiten. Basis dafür ist die Arrhenius-Gleichung, die die quantitative Veränderung der Kenngrößen bei physikalischen und chemischen Prozessen näherungsweise beschreibt. So ist die Lebensdauerfunktion eines Leistungshalbleiters zum einen abhängig von der Höhe des Hubes der Sperrschichttemperatur, zum anderen von der mittleren Sperrschichttemperatur. Verwiesen werden soll an dieser Stelle auf das Applikationshandbuch "Leistungshalbleiter" der Firma Semikron, ISBN 978-3-938843-85-7, Verlag ISLE Ilmenau, insbesondere auf das Kapitel 2.7.6 "Bewertung der Temperaturverläufe hinsichtlich der Lebensdauer". Hier wird beschrieben wie die Lebensdauer bzw. die Anzahl der möglichen Lasthübe mit steigender mittlerer Sperrschicht sinkt. Beispielsweise ist angegeben, dass die Zahl der möglichen Lastwechsel für Temperaturhübe > 30 K in der Sperrschicht um eine Zehnerpotenz je 20...30 K Zunahme der mittleren Sperrschichttemperatur sinkt. Es ist also äußerst wichtig, die mittlere Sperrschichttemperatur zu kennen und auch sicherzustellen, dass die mittlere Sperrschichttemperatur eine maximal zulässige Schwelle nicht überschreitet, da ansonsten die Temperaturhübe - bedingt durch die Verlustleistung beim Schweißvorgang - die Lebensdauer der Leistungshalbleiter überproportional beeinflussen.

Eine weitere Grundlage für die Ermittlung eines Wartungszeitpunktes stellt die Berechnung des Durchlasswiderstandes R_{DSON} der Leistungshalbleiter 125 oder der einzelnen Leistungsbauteile 100 auf Basis des fließenden Schweißstromes 180 sowie des Spannungsabfalls 246 über die Leistungshalbleiter 125 dar. Dabei wird vereinfacht ein Leistungsbauteil 100 als Parallelschaltung der in ihm angeordneten Leistungshalbleiter 125 angesehen. Dafür wird zum einen der Durchlasswiderstand R_{DSON} der Leitungsbauteile 100 während des laufenden Betriebes überwacht, zum anderen werden die ermittelten R_{DSON} Werte mit zeitlich zurückliegenden R_{DSON} Werten - insbesondere mit dem Wert von R_{DSON} bei Erstinbetriebnahme der Transformatoreinrichtung 200 bzw. der Leistungsbauteile - verglichen.

Übersteigt der Wert von R_{DSON} einen Schwellwert bzw. überschreitet die Anstiegsgeschwindigkeit von R_{DSON} einen Schwellwert, so ist ein Wartungszeitpunkt für die Transformatoreinrichtung 200 erreicht.

Bei einer adaptiven Schweißregelung (ASR) werden die Größen Schweißstrom und Spannung an den Schweißelektroden 290 als Ist-Größen für die adaptive Regelungsbetriebsart erfasst. Dieser dann ohnehin erfasste Schweißstrom 180 kann dazu genutzt werden, den Widerstand des Leistungsbauteils 100 R_{DSON} im durchgeschalteten Zustand in der Auswerteeinrichtung 260 zu berechnen. Der Spannungsabfall 246 über die Leistungshalbleiter 125 wird ebenfalls ohnehin für die Ansteuereinrichtung 140 als Ist-Größe gemessen, um die Steueranschlüsse 135 für die Halbleiter 125 anzusteuern und kann daher vorteilhaft für die Ermittlung von R_{DSON} verwendet werden. Aus dem zeitlichen Änderungsverlauf dieses Durchlasswiderstandes R_{DSON} des Leistungsbauteils 100 bzw. der Leistungshalbleiters 125 lässt sich wie beschrieben in der Auswerteeinrichtung 260 ein weiterer Parameter für die Bestimmung des Wartungszeitpunktes des Leistungsbauteils 100 und somit der Transformatoreinrichtung 200 bestimmen. Aus dem aktuellen Wert des Durchlasswiderstandes bezogen auf den Wert des Durchlasswiderstandes zu Beginn der Lebensdauer des Leistungsbauteils 100 sowie aus dessen zeitlichen Verlauf kann auf den aktuellen Verschleißzustand des Leistungsbauteils 100 geschlossen werden. So deutet eine plötzliche Erhöhung des Wertes von R_{DSON} insbesondere auf einen kurz bevorstehenden Ausfall des Leistungsbauteils 100 hin.

Über eine Kommunikationseinrichtung 250 können die erfassten Strom-/Spannungs- und Temperaturwerte auch an eine Schweißsteuerung 300 oder an eine externe Verarbeitungseinheit 400 übertragen werden. Das hat den Vorteil, dass die Berechnung des Wartungszeitpunktes und/oder des prognostizierten Lebensdauerendes der Transformatoreinrichtung 200 mit der Schweißsteuerung 300 oder mit der externen Verarbeitungseinrichtung 400 durchgeführt werden kann.

Handelt es sich bei der externen Verarbeitungseinrichtung 400 beispielsweise um einen Server des Herstellers der Transformatoreinrichtung 200, der als internetbasierte Cloudanbindung zur Verfügung gestellt wird, können die Daten einer Vielzahl von Transformatoreinrichtungen 200 gesammelt, aufbereitet und verarbeitet werden. Insbesondere ist es möglich durch maschinelles Lernen, genauere Ausfallvorhersagen für Transformatoreinrichtungen 200 beispielsweise gestaffelt nach Leistungsklassen oder Typen zu treffen. Die Algorithmen für das maschinelle Lernen können unabhängig von der Transformatoreinrichtung 200 in der Cloud angepasst, verbessert und optimiert werden. Es ist damit zum Beispiel möglich in Abhängigkeit von Herstellungsdaten, eingesetzten Leistungsbauteilen 100, eingesetzten Leistungshalbleitern 125 usw. Prognosen für das Lebensdauerende der Schweißtransformatoreinrichtung 200 zu treffen. Denkbar ist es auch Fehler in einer Produktionscharge der Transformatoreinrichtung zu erkennen. Denkbar und möglich sind weitere cloudbasierte Anwendungen. Möglich sind zum Beispiel neue Geschäftsmodelle. Durch die Verlagerung der Auswerteeinrichtung 260 und die Übertragung der Daten der Erfassungseinrichtung 240 in die Cloud ist es beispielsweise möglich, eine Nutzungsgebühr für die Schweißtransformatoreinrichtung 200 auf Basis eines nutzungsabhängigen Entgelts, wie zum beispielsweise der Anzahl der durchgeführten Schweißungen, zu erheben. Auch ist es möglich durch die Verlagerung der Auswerteeinrichtung 260 in eine Cloud des Herstellers, eine belastungsabhängige bzw. verschleißabhängige Nutzungsgebühr zu berechnen. Mit belastungsabhängiger Nutzungsgebühr ist hier insbesondere eine von der Höhe des Wertes des Temperaturhubes abhängige Berechnung der Nutzungsgebühr gemeint.

Ausgang der Auswerteeinrichtung 260 ist ein Signal, dass anzeigt, dass die Anzahl der noch möglichen Lastwechsel eine Schwelle unterschritten und damit ein Wartungszeitpunkt des Leistungsbauteils 100 und/oder der Transformatoreinrichtung 200 ansteht. Dieses Signal wird einer Signalisierungseinrichtung 270 zugeführt. Die Signalisierungseinrichtung 270 ist in der Transformatoreinrichtung 200 angeordnet und dient dazu direkt an der Schweißtransformatoreinrichtung 200 den erreichten Wartungszeitpunkt zu signalisieren. Die Signalisierungseinrichtung 270 kann als Display, Leuchtdiode etc. ausgeführt sein. Ist die Signalisierungseinrichtung 270 beispielsweise als Display ausgeführt, kann die berechnete, verbleibende Anzahl an Lasthüben darauf angezeigt werden. Alternativ wird die verbleibende Anzahl an Lasthüben beispielsweise von der externen Verarbeitungseinrichtung 400 über die erste Kommunikationseinrichtung 250 an die Signalisierungseinrichtung 270 übertragen und auf dem Display der Signalisierungseinrichtung 270 angezeigt. Dies wird durch die Pfeile in Fig. 2 gezeigt. Weiterhin kann signalisiert werden, dass der Wert von R_{DSON} schnell steigt. bzw. die Temperatur des Leistungsbauteils 100 zu hoch ist, was auf ein Problem im Kühlsystem hinweisen kann und auf einen erhöhten Verschleiß hinweist. Die Überwachung des Kühlsystems, insbesondere eines grundsätzlich vorhandenen Wasserflusses bei einer Wasserkühlung, lässt sich einfach und vorteilhaft auf Basis der erfassten Sensordaten Schweißstrom 244 und Temperatur 242, insbesondere des Verhältnisses der Anstiegsgeschwindigkeit der Temperatur zur Zeitdauer des Stromflusses realisieren. Bei zu hohem Temperaturanstieg, bezogen auf die Dauer des Schweißstromes (Energiebilanz) kann die Signalisierungseinrichtung 270 die fehlende Kühlung melden. Die Signalisierungseinrichtung 270 kann auch in der Schweißsteuerung 300 oder in der externen Verarbeitungseinrichtung 400 ausgeführt sein.

Schweißtransformatoreinrichtungen 200 werden häufig an Schweißrobotern (hier nicht dargestellt) montiert. Ist die Signalisierungseinrichtung 270 aus diesem oder anderen Gründen nicht leicht einsehbar, so überträgt eine zweite drahtlose Kommunikationseinrichtung 280 zusätzlich oder alternativ das Wartungssignal über ein drahtloses Protokoll wie Bluetooth, LoRa und/oder ZigBee oder über ein drahtgebundenes Protokoll wie Sercos oder Ethernet an ein Fertigungsmanagementsystem des Betreibers der Schweißanlage oder an ein mobiles Gerät eines Mitarbeiters des Betreibers der Transformatoreinrichtung 200 um einen Wartungszustand bzw. eine Wartungsanforderung der Transformatoreinrichtung 200 oder ein Problem des Kühlsystems der Transformatoreinrichtung 200 zu signalisieren. Der Betreiber der Anlage oder der Mitarbeiter des Betreibers kann die entsprechenden Schritte für eine Wartung der Transformatoreinrichtung 200 aktivieren. Somit ist es einfach möglich, einem Ausfall der Transformatoreinrichtung 200 und dadurch bedingten Ausfallzeiten der gesamten Anlage des Betreibers zuvorzukommen.

Offenbart wird ein Leistungsbauteil zur Steuerung eines elektrischen Starkstromes umfassend eine Stromeingangsplatte, eine Stromausgangsplatte und einen Bauteilträger zwischen diesen Platten mit mindestens zwei auf ihm angeordneten parallelgeschalteten Leistungshalbleiterventilen und mit wenigstens einem Steueranschluss zur Ansteuerung der Leistungshalbleiterventile, bei dem ein Temperaturfühler vorgesehen ist, der zwischen der Stromeingangsplatte und der Stromausgangsplatte und zwischen den mindestens zwei Leistungshalbleiterventilen angeordnet ist.

### Bezugszeichenliste

- 100: Leistungsbauteil
- 105: Stromeingangsplatte
- 110: Stromausgangsplatte
- 120: Bauteilträger
- 125: Leistungshalbleiter
- 130: Halbleitergehäuse
- 135: Steueranschluss
- 140: Ansteuereinrichtung
- 145: Kontakte
- 150: Stecker
- 155: Sinterpaste
- 160: Durchkontaktierung
- 165: Verbindungsmittel
- 170: Temperaturfühler
- 180: Starkstrom
- 190: abgeführte Wärme
- 200: Transformatoreinrichtung
- 210: Transformator
- 220: Primärwicklung
- 230: Sekundärwicklung
- 235: Mittelanzapfung
- 240: Erfassungseinrichtung
- 242: Temperaturmesssignal
- 244: Strommesssignal
- 246: Spannungsmesssignal
- 250: erste Kommunikationseinrichtung
- 260: Auswerteeinrichtung
- 270: Signalisierungseinrichtung
- 280: zweite Kommunikationseinrichtung
- 290: Schweißelektroden
- 300: Schweißsteuerung
- 400: externe Verarbeitungseinheit

## Patentansprüche

1. Transformatoreinrichtung mit einem Transformator (210) zum Widerstandschweißen umfassend eine Primärwicklung (220) und eine Sekundärwicklung (230), mit einem Gleichrichter mit mindestens einem Leistungsbauteil (100) zur Steuerung eines elektrischen Starkstromes (180), wobei das Leistungsbauteil (100) eine Stromeingangsplatte (105), eine Stromausgangsplatte (110) und einen Bauteilträger (120) zwischen diesen Platten (105, 110) mit mindestens zwei auf ihm angeordneten parallelgeschalteten Leistungshalbleiterventilen (125) umfasst, deren Stromausgänge mit der Stromausgangsplatte (110) mittelbar mittels elektrischer Verbindungsmittel (160) elektrisch leitend verbunden sind, die als vertikale Durchkontaktierungen durch den Bauteilträger (120) ausgestaltet sind, und mit wenigstens einem Steueranschluss (135) zur Ansteuerung der Leistungshalbleiterventile (125), und wobei die Transformatoreinrichtung zudem eine Ansteuereinrichtung (140) umfasst, die dazu eingerichtet ist, den Steueranschluss (135) des Leistungsbauteils (100) zur Gleichrichtung des elektrischen Starkstromes (180) der Sekundärwicklung (230) des Transformators (210) anzusteuern, **dadurch gekennzeichnet, dass** ein Temperaturfühler (170) vorgesehen ist, der zwischen der Stromeingangsplatte (105) und der Stromausgangsplatte (110) und zwischen den mindestens zwei Leistungshalbleiterventilen (125) und auf dem Bauteilträger (120) direkt an einer der Durchkontaktierungen (160) durch den Bauteilträger (120) angeordnet ist, und dass eine Erfassungseinrichtung (240) vorhanden ist, die mit dem Temperaturfühler (170) des Leistungsbauteils (100) verbunden ist, und die dazu eingerichtet ist, einen zeitlichen Verlauf einer vom Temperaturfühler (170) gemessenen Temperatur der mindestens zwei Leistungshalbleiterventile (125) des Leistungsbauteils (100) zu erfassen.

2. Transformatoreinrichtung nach Anspruch 1, **dadurch gekennzeichnet, dass** der Temperaturfühler (170) entweder ein Kaltleiter mit einem positiven Temperaturkoeffizienten oder ein Heißleiter mit einem negativen Temperaturkoeffizienten ist.

3. Transformatoreinrichtung nach Anspruch 1 oder 2, **dadurch gekennzeichnet, dass** weitere Temperaturfühler (170) an den Durchkontaktierungen der Stromausgänge weiterer Leistungshalbleiter (125) auf dem Bauteilträger (120) angeordnet sind.

4. Transformatoreinrichtung nach einem der vorhergehenden Ansprüche, **dadurch gekennzeichnet, dass** ein Anschluss des Temperaturfühlers (170) und/oder der wenigstens eine Steueranschluss (135) zur Ansteuerung der Leistungshalbleiterventile (125) auf dem Bauteilträger (120) zu Kontakten (145) eines Steckers (150) des Bauteilträgers (120) nach außen geführt ist.

5. Transformatoreinrichtung nach Anspruch 4, **dadurch gekennzeichnet, dass** der Stecker (150) des Bauteilträgers (120) seitlich über die Stromeingangsplatte (105) und/oder die Stromausgangsplatte (110) heraussteht.

6. Transformatoreinrichtung nach einem der vorangehenden Ansprüche, **dadurch gekennzeichnet, dass** mindestens eine erste Kommunikationseinrichtung (250) vorhanden ist, die dazu eingerichtet ist, den gemessenen zeitlichen Verlauf der Temperatur der mindestens zwei Leistungshalbleiterventile (125) des Leistungsbauteils (100) an eine Schweißsteuerung (300) und/oder an eine externe Verarbeitungseinrichtung (400) zu übertragen.

7. Transformatoreinrichtung nach einem der vorangehenden Ansprüche, **dadurch gekennzeichnet, dass** eine Auswerteeinrichtung (260) vorhanden ist, die dazu eingerichtet ist, auf Basis des mit der Erfassungseinrichtung (240) gemessenen zeitlichen Verlaufs der Temperatur und/oder auf Basis über eine vorgegebene Zeit aggregierter Temperaturhübe des Leistungshalbleiters (125) eine Kalkulation eines Wartungszeitpunktes und/oder eines prognostizierten Lebensdauerendes der Transformatoreinrichtung (200) durchzuführen.

8. Transformatoreinrichtung nach Anspruch 7, **dadurch gekennzeichnet, dass** die Auswerteeinrichtung (260) zur Kalkulation des Wartungszeitpunktes und/oder des prognostizierten Lebensdauerendes in der Schweißsteuerung (300) und/oder in der externen Verarbeitungseinrichtung angesiedelt (400) ist.

9. Transformatoreinrichtung nach Anspruch 8, **dadurch gekennzeichnet, dass** die mindestens eine erste Kommunikationseinrichtung (250) dazu eingerichtet ist, den kalkulierten Wartungszeitpunkt und/oder das prognostizierte Lebensdauerende der Transformatoreinrichtung (200) von der Schweißsteuerung (300) und/oder von der externen Verarbeitungseinrichtung (400) zu empfangen.

10. Transformatoreinrichtung nach einem der Ansprüche 7 bis 9, **dadurch gekennzeichnet, dass** eine Signalisierungseinrichtung (270) vorhanden ist, die dazu eingerichtet ist, den erreichten Wartungszeitpunkt und/oder das prognostizierte Lebensdauerende der Transformatoreinrichtung (200) anzuzeigen.

11. Transformatoreinrichtung nach einem der Ansprüche 7 bis 10, **dadurch gekennzeichnet, dass** eine zweite Kommunikationseinrichtung (280) vorhanden ist, die dazu eingerichtet ist, den erreichten Wartungszeitpunkt der Transformatoreinrichtung (200) zu kommunizieren.

12. Transformatoreinrichtung nach Anspruch 11, **dadurch gekennzeichnet, dass** die zweite Kommunikationseinrichtung (280) dazu eingerichtet, den erreichten Wartungszeitpunkt der Transformatoreinrichtung (200) über ein Protokoll wie Bluetooth, LoRa und/oder ZigBee drahtlos zu kommunizieren.

13. Transformatoreinrichtung nach einem der vorangehenden Ansprüche, **dadurch gekennzeichnet, dass** die Erfassungseinrichtung (240) weiterhin dazu eingerichtet ist, den zeitlichen Verlauf des Spannungsabfalls (246) über die Leistungshalbleiter (125) des Leistungsbauteils (100) und/oder den zeitlichen Stromverlauf (244) der Sekundärwicklung (230) und/oder der Primärwicklung (220) des Transformators (210) zu erfassen.

14. Transformatoreinrichtung nach Anspruch 13, **dadurch gekennzeichnet, dass** die mindestens eine erste Kommunikationseinrichtung (250) weiterhin dazu eingerichtet ist, den gemessenen zeitlichen Verlauf des Spannungsabfalls (246) über die Leistungshalbleiter (125) des Leistungsbauteils (100) und/oder den zeitlichen Stromverlauf (244) des Transformators (210) an die Schweißsteuerung (300) und/oder an die externe Verarbeitungseinrichtung (400) zu übertragen.

15. Transformatoreinrichtung nach einem der Ansprüche 12 bis 14, **dadurch gekennzeichnet, dass** die Auswerteeinrichtung (260) weiterhin dazu eingerichtet ist, einen Verschleiß der mindestens zwei Halbleiterventile (125) aus dem von der Erfassungseinrichtung (240) erfassten zeitlichen Verlauf des Spannungsabfalls (246) und/oder aus dem von der Erfassungseinrichtung (240) erfassten zeitlichen Stromverlauf (244) zu berechnen.

16. Transformatoreinrichtung nach Anspruch 15, **dadurch gekennzeichnet, dass** die Kalkulation des erreichten Wartungszeitpunkts und/oder das prognostizierte Lebensdauerende der Transformatoreinrichtung (200) unter Berücksichtigung des kalkulierten Verschleißes der mindestens zwei Halbleiterventile (125) erfolgt.

## Claims

1. Transformer device having a transformer (210) for resistance welding, comprising a primary winding (220) and a secondary winding (230), having a rectifier having at least one power component (100) for controlling a heavy electric current (180), the power component (100) comprising a current input plate (105), a current output plate (110) and a component mount (120) between these plates (105, 110) having at least two parallel-connected power semiconductor valves (125) arranged on it, the current outputs of which power semiconductor valves are electrically conductively connected to the current output plate (110) indirectly by means of electrical connecting means (160) which are in the form of vertical plated-through holes through the component mount (120), and having at least one control connection (135) for actuating the power semiconductor valves (125), and the transformer device additionally comprising an actuation device (140) which is configured to actuate the control connection (135) of the power component (100) to rectify the heavy electric current (180) of the secondary winding (230) of the transformer (210), **characterized in that** there is provision for a temperature sensor (170) which is arranged between the current input plate (105) and the current output plate (110) and between the at least two power semiconductor valves (125) and on the component mount (120) directly at one of the plated-through holes (160) through the component mount (120), and **in that** a capture device (240) is present which is connected to the temperature sensor (170) of the power component (100) and which is configured to capture a time characteristic of a temperature, measured by the temperature sensor (170), of the at least two power semiconductor valves (125) of the power component (100).

2. Transformer device according to Claim 1, **characterized in that** the temperature sensor (170) is either a PTC thermistor having a positive temperature coefficient or an NTC thermistor having a negative temperature coefficient.

3. Transformer device according to Claim 1 or 2, **characterized in that** further temperature sensors (170) are arranged on the component mount (120) at the plated-through holes of the current outputs of further power semiconductors (125).

4. Transformer device according to one of the preceding claims, **characterized in that** a connection of the temperature sensor (170) and/or the at least one control connection (135) for actuating the power semiconductor valves (125) is routed to the outside on the component mount (120) to contacts (145) of a connector (150) of the component mount (120).

5. Transformer device according to Claim 4, **characterized in that** the connector (150) of the component mount (120) protrudes laterally beyond the current input plate (105) and/or the current output plate (110).

6. Transformer device according to one of the preceding claims, **characterized in that** at least one first communication device (250) is present which is configured to transmit the measured time characteristic of the temperature of the at least two power semiconductor valves (125) of the power component (100) to a welding controller (300) and/or to an external processing device (400).

7. Transformer device according to one of the preceding claims, **characterized in that** an evaluation device (260) is present which is configured to calculate a maintenance time and/or a predicted end of life for the transformer device (200) on the basis of the temperature time characteristic measured by the capture device (240) and/or on the basis of temperature swings of the power semiconductor (125) that are aggregated over a predefined time.

8. Transformer device according to Claim 7, **characterized in that** the evaluation device (260) for calculating the maintenance time and/or the predicted end of life is located (400) in the welding controller (300) and/or in the external processing device.

9. Transformer device according to Claim 8, **characterized in that** the at least one first communication device (250) is configured to receive the calculated maintenance time and/or the predicted end of life of the transformer device (200) from the welding controller (300) and/or from the external processing device (400).

10. Transformer device according to one of Claims 7 to 9, **characterized in that** a signaling device (270) is present which is configured to indicate the reached maintenance time and/or the predicted end of life of the transformer device (200).

11. Transformer device according to one of Claims 7 to 10, **characterized in that** a second communication device (280) is present which is configured to communicate the reached maintenance time of the transformer device (200).

12. Transformer device according to Claim 11, **characterized in that** the second communication device (280) is configured to wirelessly communicate the reached maintenance time of the transformer device (200) using a protocol such as Bluetooth, LoRa and/or ZigBee.

13. Transformer device according to one of the preceding claims, **characterized in that** the capture device (240) is furthermore configured to capture the time characteristic of the voltage drop (246) across the power semiconductors (125) of the power component (100) and/or the current time characteristic (244) of the secondary winding (230) and/or the primary winding (220) of the transformer (210).

14. Transformer device according to Claim 13, **characterized in that** the at least one first communication device (250) is furthermore configured to transmit the measured time characteristic of the voltage drop (246) across the power semiconductors (125) of the power component (100) and/or the current time characteristic (244) of the transformer (210) to the welding controller (300) and/or to the external processing device (400).

15. Transformer device according to one of Claims 12 to 14, **characterized in that** the evaluation device (260) is furthermore configured to calculate a wear on the at least two semiconductor valves (125) from the time characteristic of the voltage drop (246) captured by the capture device (240) and/or from the current time characteristic (244) captured by the capture device (240).

16. Transformer device according to Claim 15, **characterized in that** the reached maintenance time and/or the predicted end of life of the transformer device (200) is/are calculated in consideration of the calculated wear on the at least two semiconductor valves (125).

## Revendications

1. Dispositif transformateur comportant un transformateur (210) destiné au soudage par résistance, comprenant une bobine primaire (220) et une bobine secondaire (230), ayant un redresseur doté d'au moins un composant de puissance (100) pour commander un courant électrique de forte intensité (180), le composant de puissance (100) comprenant une plaque d'entrée de courant (105), une plaque de sortie de courant (110) et un support de composant (120) entre ces plaques (105, 110) doté d'au moins deux valves à semi-conducteur de puissance (125) montées en parallèle sur celui-ci, dont les sorties de courant sont indirectement connectées de manière électriquement conductrice à la plaque de sortie de courant (110) à l'aide de moyens de connexion électriques (160), qui sont conçus sous forme de trous d'interconnexion métallisés verticaux à travers le support de composant (120), et ayant au moins une borne de commande (135) pour commander les valves à semi-conducteur de puissance (125), et le dispositif transformateur comprenant en outre un dispositif d'attaque (140) qui est conçu pour attaquer la borne de commande (135) du composant de puissance (100) pour redresser le courant électrique de forte intensité (180) de la bobine secondaire (230) du transformateur (210), **caractérisé en ce qu'**il est prévu un capteur de température (170) qui est disposé directement entre la plaque d'entrée de courant (105) et la plaque de sortie de courant (110) et entre lesdites au moins deux valves à semi-conducteur de puissance (125) et sur le support de composant (120) au niveau de l'un des trous d'interconnexion métallisés (160) à travers le support de composant (120), et **en ce qu'**un dispositif de détection (240) est présent, lequel est connecté au capteur de température (170) du composant de puissance (100), et est conçu pour détecter une évolution temporelle d'une température, mesurée par le capteur de température (170), desdites au moins deux valves à semi-conducteur de puissance (125) du composant de puissance (100).

2. Dispositif transformateur selon la revendication 1, **caractérisé en ce que** le capteur de température (170) est soit une thermistance à coefficient de température positif, soit une thermistance à coefficient de température négatif.

3. Dispositif transformateur selon la revendication 1 ou 2, **caractérisé en ce que** d'autres capteurs de température (170) sont disposés sur le support de composant (120) au niveau des trous d'interconnexion métallisés des sorties de courant d'autres semi-conducteurs de puissance (125).

4. Dispositif transformateur selon l'une des revendications précédentes, **caractérisé en ce qu'**une borne du capteur de température (170) et/ou ladite au moins une borne de commande (135) destinée à la commande des valves à semi-conducteur de puissance (125)est acheminée vers l'extérieur sur le support de composant (120) jusqu'à des contacts (145) d'un connecteur (150) du support de composant (120).

5. Dispositif transformateur selon la revendication 4, **caractérisé en ce que** le connecteur (150) du support de composant (120) fait saillie latéralement au-delà de la plaque d'entrée de courant (105) et/ou de la plaque de sortie de courant (110).

6. Dispositif transformateur selon l'une des revendications précédentes, **caractérisé en ce qu'**au moins un premier dispositif de communication (250) est présent, lequel est conçu pour transmettre l'évolution temporelle mesurée de la température desdites au moins deux valves à semi-conducteur de puissance (125) du composant de puissance (100) à un dispositif de commande de soudage (300) et/ou à un dispositif de traitement externe (400).

7. Dispositif transformateur selon l'une des revendications précédentes, **caractérisé en ce qu'**un dispositif d'évaluation (260) est présent, lequel est conçu pour effectuer un calcul d'un moment de maintenance et/ou d'une fin de vie utile prévue du dispositif transformateur (200) sur la base de l'évolution temporelle de la température mesurée par le dispositif de détection (240) et/ou sur la base des variations de température agrégées sur une période prédéfinie du semi-conducteur de puissance (125).

8. Dispositif transformateur selon la revendication 7, **caractérisé en ce que** le dispositif d'évaluation (260) destiné à calculer le moment de maintenance et/ou la fin de vie utile prévue est situé dans le dispositif de commande de soudage (300) et/ou dans le dispositif de traitement externe (400).

9. Dispositif transformateur selon la revendication 8, **caractérisé en ce que** ledit au moins un premier dispositif de communication (250) est conçu pour recevoir le moment de maintenance calculé et/ou la fin de vie utile prévue du dispositif transformateur (200) en provenance du dispositif de commande de soudage (300) et/ou en provenance du dispositif de traitement externe (400).

10. Dispositif transformateur selon l'une des revendications 7 à 9, **caractérisé en ce qu'**un dispositif de signalisation (270) est présent, lequel est conçu pour indiquer le moment de maintenance atteint et/ou la fin de vie utile prévue du dispositif transformateur (200).

11. Dispositif transformateur selon l'une des revendications 7 à 10, **caractérisé en ce qu'**un second dispositif de communication (280) est présent, lequel est conçu pour communiquer le moment de maintenance atteint du dispositif transformateur (200).

12. Dispositif transformateur selon la revendication 11, **caractérisé en ce que** le second dispositif de communication (280) est conçu pour communiquer sans fil le moment de maintenance atteint du dispositif transformateur (200) par l'intermédiaire d'un protocole tel que Bluetooth, LoRa et/ou ZigBee.

13. Dispositif transformateur selon l'une des revendications précédentes, **caractérisé en ce que** le dispositif de détection (240) est en outre conçu pour détecter l'évolution temporelle de la chute de tension (246) aux bornes des semi-conducteurs de puissance (125) du composant de puissance (100) et/ou l'évolution temporelle du courant (244) de la bobine secondaire (230) et/ou de la bobine primaire (220) du transformateur (210).

14. Dispositif transformateur selon la revendication 13, **caractérisé en ce que** ledit au moins un premier dispositif de communication (250) est en outre conçu pour transmettre l'évolution temporelle mesurée de la chute de tension (246) aux bornes des semi-conducteurs de puissance (125) du composant de puissance (100) et/ou l'évolution temporelle du courant (244) du transformateur (210) au dispositif de commande de soudage (300) et/ou au dispositif de traitement externe (400).

15. Dispositif transformateur selon l'une des revendications 12 à 14, **caractérisé en ce que** le dispositif d'évaluation (260) est en outre conçu pour calculer une usure desdites au moins deux valves à semi-conducteur (125) à partir de l'évolution temporelle de la chute de tension (246) détectée par le dispositif de détection (240) et/ou à partir de l'évolution temporelle du courant (244) détectée par le dispositif de détection (240).

16. Dispositif transformateur selon la revendication 15, **caractérisé en ce que** le calcul du moment de maintenance atteint et/ou de la fin de vie utile prévue du dispositif transformateur (200) est effectué en tenant compte de l'usure calculée desdites au moins deux valves à semi-conducteur (125).
